# EUROPÄISCHE PATENTSCHRIFT

(11) **EP 3 074 550 B1**
(45) Veröffentlichungstag und Bekanntmachung des Hinweises auf die Patenterteilung: **11.04.2018**
(21) Anmeldenummer: 14873980.8
(22) Anmeldetag: 01.12.2014
(51) Int. Cl.: C23C 14/06

(54) **BESCHICHTUNG MIT MO-N BASIERTER SCHICHT MIT DELTA-PHASE DES MOLYBDÄNNITRIDS**
COATING COMPRISING A MO-N-BASED LAYER IN WHICH THE MOLYBDENUM NITRIDE IS PROVIDED AS A DELTA PHASE
REVÊTEMENT DOTÉ D'UNE COUCHE À BASE DE MO-N COMPRENANT LA PHASE DELTA DU NITRURE DE MOLYBDÈNE

(30) Priorität: 29.11.2013 DE 102013018007; 26.11.2014 WO PCT/EP2014/003151
(43) Veröffentlichungstag der Anmeldung: 05.10.2016
(73) Patentinhaber: Oerlikon Surface Solutions AG, Pfäffikon, 8808 Pfäffikon (CH)
(72) Erfinder: RAMM, Jürgen, CH-7304 Maienfeld (CH); KARNER, Johann, FL-9495 Triesen (LI)
(74) Vertreter: Misselhorn, Hein-Martin
(86) Internationale Anmeldenummer: PCT/EP2014/003200
(87) Internationale Veröffentlichungsnummer: WO 2015/096882

(56) Entgegenhaltungen:
- SARIOGLU C ET AL: "Measurement of residual stresses by X-ray diffraction techniques in MoN and Mo2N coatings deposited by arc PVD on high-speed steel substrate", SURFACE AND COATINGS TECHNOLOGY, ELSEVIER, AMSTERDAM, NL, Bd. 190, Nr. 2-3, 21. Januar 2005 (2005-01-21), Seiten 238-243, XP004653603, ISSN: 0257-8972, DOI: 10.1016/J.SURFCOAT.2004.08.184
- KAZMANLI M K ET AL: "Effect of nitrogen pressure, bias voltage and substrate temperature on the phase structure of Mo-N coatings produced by cathodic arc PVD", SURFACE & COATINGS TECHNOLOGY ELSEVIER SWITZERLAND, Bd. 167, Nr. 1, 1. April 2003 (2003-04-01) , Seiten 77-82, XP002742143, ISSN: 0257-8972

## Beschreibung

Die vorliegende Erfindung betrifft ein Schichtsystem, welches mindestens eine Molybdännitrid-Schicht umfasst, wobei die Schicht die charakteristischen sehr guten Gleiteigenschaften des hexagonalen Molybdännitrids, aber gleichzeitig auch eine "angemessene" Härte aufweist, welche zwischen 2600 HV und 3700 HV (Vickers Härte) oder zwischen 26-27 GPa und 37-38 GPa (Indentationshärte HIT) liegt.

Die vorliegende Erfindung betrifft ebenfalls eine Methode zur Oberflächenbehandlung von Bauteilen, wobei zumindest eine Oberfläche eines Bauteils erfindungsgemäss beschichtet und vorzugsweise anschliessend mit Hilfe eines Bürstverfahrens nachbehandelt wird, damit sowohl verbesserte Gleiteigenschaften als auch vermindernder Gegenkörperverschleiss bei tribologischen Anwendungen erreicht werden.

### Stand der Technik

Die Verwendung von Molybdännitrid- oder Molybdännitrid-basierten Schichten als Beschichtung von Bauteilen ist aus dem Stand der Technik gut bekannt.

Ramm offenbart beispielsweise in DE102010053751 A1, dass Schichtsysteme mit einer Molybdän-Nitrid-Schicht zum Beschichten von Bauelementen, bspw. Gleitelementen, verwendet werden können. Dort wird gelehrt, dass durch die Beschichtung von Bauteiloberflächen mit einer Molybdännitrid-Schicht sowohl Reibungskoeffizienten gegen Stahl als auch Stahl-Aufschmierungen auf die beschichteten Bauteiloberflächen vermindert werden können. Das XRD-Diffraktogramm in der Abbildung 4 des Dokuments DE102010053751A1 zeigt, dass die offenbarten Molybdännitrid-Schichten vornehmlich eine kubische Struktur aufweisen, welche auf die Gamma- oder Zeta-Phase des Molybdännitrids hinweist. Zudem wird angegeben, dass diese Schichten eine Schichthärte von ca. 3000 HV aufweisen und mittels eines PVD-Arc-Verfahrens unter Verwendung von Molybdän-Targets in einer reaktiven Stickstoffatmosphäre abgeschieden wurden, wobei eine Beschichtungstemperatur von 450 °C, ein Stickstoffdruck von 3.5 Pa und eine negative Substratbias-Spannung von -20 V verwendet wurden. Die Reibkoeffizienten wurden sowohl für beschichtete Oberflächen, die nachträglich poliert wurden, als auch für beschichtete Oberflächen, die nach dem Beschichten keiner Nachbehandlung unterzogen wurden, ermittelt. Ramm schlägt in DE102010053751 A1 auch eine weitere Schicht vor, die aus Molybdänmonoxid oder aus Molybdänoxinitrid besteht und als oberste Schicht der Beschichtung verwendet wird. Ferner wird hingewiesen, dass das Wachstum verschiedener Phasen des Molybdännitrids durch die Einstellung von Pulsparametern gut reguliert werden kann, wenn die Molybdännitrid-Schicht beispielsweise mittels gepulstem Funkenverdampfens und/oder unter Verwendung einer gepulstem Bias-Spannung abgeschieden wird.

Ürgen et.al berichten in Surface and Coatings Technology 94-95 (1997) 501-506 über Molybdännitrid-Schichten, welche mittels PVD-Arc-Verdampfen von Molybdän-Targets in einer reaktiven Stickstoffatmosphäre abgeschieden wurden. Molybdännitrid-Schichten mit unterschiedlichen Phasen wurden durch Variation des Stickstoffdrucks produziert, wobei die Beschichtungstemperatur zwischen 450 °C und 500 °C gehalten und eine negative Substratbias-Spannung von -50 V verwendet wurde. Ürgen berichtet, dass die Bildung der kubischen Gamma-Phase (γ-Mo₂N) des Molybdännitrids durch die Verwendung eines niedrigen Stickstoffdrucks von 0.4 Pa oder 0.8 Pa und die Bildung der hexagonalen Delta-Phase (δ-MoN) des Molybdännitrids durch die Verwendung eines höheren Stickstoffdrucks von 1.2 Pa oder 1.8 Pa begünstigt wurde. Die γ-Mo₂N umfassenden Schichten wiesen Härtewerte von 30000 N/mm² bis 36000 N/mm² auf, während die δ-MoN umfassenden Schichten höhere Härtewerte von ca. 38000 N/mm² und höher aufwiesen. Tribologische Tests mit nachpolierten Molybdännitrid-Schichten zeigten, dass Molybdännitrid-Schichten mit höherem Stickstoffgehalt bessere Verschleisseigenschaften, niedrigere Reibungskoeffizienten und verminderte Neigung zur Rissbildung aufweisen.

Maier schlägt in DE102012207814A1 vor, Bauelemente, insbesondere Gleitelemente, mit einer Schutzbeschichtung zu beschichten, welche eine Hauptschicht aufweist, deren Hauptbestandteile Molybdän und Stickstoff sind, wobei vorzugsweise die Hauptschicht als Molybdännitrid-Schicht ausgebildet sein soll, die Schutzbeschichtung mittels eines PVD-Arc-Verfahrens auf das Bauelement aufgebracht werden soll, und die Hauptschicht nach der Schichtabscheidung durch Feinschleifen oder/und Läppen oder/und Honen oder/und Polieren eingeebnet werden soll. Dennoch offenbart Maier keine klaren Beschichtungsparameter für die Abscheidung der Molybdännitrid-Schicht als Hauptschicht. Es wird nur erwähnt, dass die Hauptschicht einen Stickstoffgehalt von vorzugsweise 20-60 at% haben kann. Jedoch wird ein niedrigerer Stickstoffgehalt von 25-40 at% bevorzugt. Insbesondere wird ein Stickstoffgehalt von 30-35 at% höchst bevorzugt. Es wird zusätzlich erwähnt, dass die Härte der Hauptschicht vorzugsweise zwischen 1500 HV und 2200 HV liegen soll, um eine besonders hohe mechanische Stabilität des Bauelements sicherzustellen. Da Maier eine Kombination von niedriger Härte und niedrigem Stickstoffgehalt für die Hauptschicht vorschlägt, kann man daraus schliessen, dass eine zumindest im Wesentlichen eine Gamma-phase (γ-Mo₂N) umfassende Molybdännitrid-Schicht als Hauptschicht am besten geeignet für die Beschichtung von Gleitelementen ist.

Auch Kazmanli et al. berichten in Surface and Coatings Technology 167 (2003) 77-82 über die Abscheidung von Molybdännitrid-Schichten mittels PVD-Arc-Verfahren, bei denen Molybdän-Targets in einer reaktiven Stickstoffatmosphäre verdampft werden. Kazmanli lehrt in ähnlicher Weise wie Ürgen, dass die Bildung von reinem γ-Mo₂N grundsätzlich durch die Verwendung eines niedrigen Stickstoffdrucks von beispielweise 0.8 Pa oder 0.4 Pa und die Bildung von reinem δ-MoN durch die Verwendung eines höheren Stickstoffdrucks von beispielweise 1.9 Pa begünstigt wird. Kazmanli berichtete aber auch über die Bildung von gemischten Gamma- und Delta-Phasen unter Verwendung eines mittleren Stickstoffdrucks von beispielweise 1.2 Pa oder 1.5 Pa. Ausserdem lehrt Kazmanli, dass die Bias-Spannung und die Substrattemperatur bei der Abscheidung von Molybdännitrid-Schichten eine wichtige Rolle spielen kann. Eine hohe negative Bias-Spannung von beispielweise -250 V bis -350 V soll zu einer Erhöhung der Energie der Mo-Ionen führen, welche die Bildung der Gamma-Phase begünstigen könnte. Eine niedrige negative Bias-Spannung von beispielweise -50 V bis -150 V soll hingegen die Bildung der Delta-Phase ermöglichen. Kazmanli berichtete zusätzlich, dass Molybdännitrid-Schichten, welche bei einer Substrattemperatur von 300 °C bis 380 °C abgeschieden wurden, die Bildung der Delta-Phase zeigten, während'Molybdännitrid-Schichten, welche bei einer höheren Substrattemperatur von 410 °C bis 510 °C abgeschieden wurden, die Bildung einer Mischung von Gamma- und Delta-Phase zeigten, wobei für die Abscheidung beider Varianten ein Stickstoffdruck von 1 Pa und eine negative Bias-Spannung von -150 V verwendet wurden. Die Härtewerte der untersuchtenMolybdännitrid-Schichten lagen bei ca. 3372 HV für die Gamma-Phase Schichten, bei ca. 5085 HV für die Delta-Phase Schichten und bei ca. 4750 HV für die gemischten Gamma-und Delta-Phase Schichten.

Desgleichen berichtet Hanbey Hazar in Materials and Design 31 (2010) 624-627 über Molybdännitrid-Schichten, welche auf Diesel-Motor-Teile mittels eines Arc-PVD-Verfahrens und unter Verwendung einer Beschichtungstemperatur von 300 °C, einem Arc-Strom von 125 A, eines Beschichtungsdrucks von 0.4 Pa und einer negativen Biasspannung von -100 V abgeschieden wurden. Es wurde nicht spezifiziert, ob beim Beschichtungsprozess nur Stickstoffgas oder ein stickstoffhaltiges Gas in die Beschichtungskammer eingelassen wurde. Im Gegensatz zu Kazmanli berichtet Hanbey Hazar über Molybdännitrid-Schichten mit Delta-Phase, aber mit einer Schichthärte von 2000 HV, welche viel niedriger ist aus die, welche durch Kazmanli berichtet wurde.

### Beschreibung des technischen Problems

Gemäss der Lehre der oben zitierten Dokumente ist das Beschichten von Gleitelementen mit Molybdännitrid-Schichten, welche mittels Arc-PVD abgeschieden werden, und das nachträgliche Polieren der beschichteten Oberflächen von Vorteil.

Jedoch gibt es keinen klaren Hinweis, ob zur Verbesserung von Gleiteigenschaften eine Molybdännitrid-Schicht mit ausschliesslich oder hauptsächlich γ-Mo₂N, oder eine Molybdännitrid-Schicht mit ausschliesslich oder hauptsächlich δ-MoN, oder eine Molybdännitrid-Schicht mit sowohl γ-Mo₂N als auch δ-MoN am besten geeignet ist.

Gleichzeitig ist es auch nicht klar, welche Härtewerte für welche Phase wirklich erreichbar und am besten geeignet sind.

Desgleichen ist es nicht klar, welche Parameter man zur Abscheidung einer vorgegebenen Kombination von einer gewissen Phase oder eine gewisse Mischung von Phasen des Molybdännitrids und einer bestimmten Schichthärte verwenden soll.

Hinsichtlich des Nachpolierens der mit Molybdännitrid-Schichten beschichteten Oberflächen ist es nicht klar, wie ein Polierverfahren zur Nachbehandlung von Bauteiloberflächen industriell eingesetzt werden kann. Das vor allem, weil die Verwendung solcher Verfahren in der industriellen Produktion für die Nachbehandlung von beschichteten Bauteilen mit komplexen Formen, wie es beispielsweise Kolbenbolzen und Kolbenringe sind, sehr teuer und aufwändig ist.

Für die Verwendung eines einfachen und günstigeren Verfahrens, wie es beispielweise das Bürstverfahren ist, welches im industriellen Produktionsumfeld sich für die Nachbehandlung von mit Molybdännitrid beschichteten Bauteilen gut anwenden lassen würde, wäre es dann erwünscht bzw. erforderlich, dass die Molybdännitrid-Schichten sich gut bürsten lassen und tendenziell eher eine reduzierte Härte aufweisen, welche vorzugsweise nicht höher als 3700 HV ist.

Wiederum ist aber für viele tribologische Anwendungen eine zu geringe Schichthärte auch nicht erwünscht. Deswegen sollte die Härte der Molybdännitrid-Schichten womöglich gleich oder vorzugsweise grösser 2600 HV sein.

### Aufgabe der vorliegenden Erfindung

Es ist eine Aufgabe der vorliegenden Erfindung, eine Molybdännitrid-Schicht und eine Methode zu deren Herstellung bereitzustellen, wobei die Schicht sehr gute Gleiteigenschaften und gleichzeitig eine "angemessene" Schichthärte aufweist, welche vorzugsweise nicht niedriger als 2600 HV und nicht grösser als 3700 HV ist.

Es ist eine weitere Aufgabe der vorliegenden Erfindung, ein wirtschaftliches. Verfahren zur Nachbehandlung von Molybdännitrid-Schichten bereitzustellen.

### Beschreibung der vorliegenden Erfindung

Die Aufgabe der vorliegenden Erfindung wird dadurch gelöst, indem eine Beschichtung wie im Anspruch 1 und ein Beschichtungsverfahren wie im Anspruch 12 bereitgestellt wird.

Die vorliegende Erfindung betrifft eine Beschichtung, umfassend zumindest eine Mo-N basierte Hartstoffschicht, welche zumindest grösstenteils die hexagonale Phase des Molybdännitrids δ-MoN umfasst, wobei das Intensitätsverhältnis der beiden Peaks (δ-MoN 220)/(δ-MoN 200) ≥3 ist, vorzugsweise ≥ 10, besonders bevorzugt ≥ 30.

Die erfindungsgemässe Mo-N basierte Hartstoffschicht wird vorzugsweise als oberste Schicht der Beschichtung abgeschieden.

Bei gewissen Anwendungen wurde festgestellt, dass es vorteilhaft sein kann, wenn die Beschichtung lediglich eine oder mehrere Mo-N basierte Hartstoffschichten umfasst. Jedoch kann das Hartstoffschichtsystem auch Schichten aus anderen Materialien umfassen, welche zum Beispiel als Haftschichten oder Stützschichten oder als andere Art von Schichten dienen können.

Gemäss einer bevorzugten Ausführungsform der vorliegenden Erfindung besteht die Mo-N basierte Hartstoffschicht vorzugsweise im Wesentlichen aus Molybdännitrid.

Gemäss noch einer bevorzugten Ausführungsform der vorliegenden Erfindung weist die Mo-N basierte Hartstoffschicht eine Vickershärte zwischen 2600 HV und 3700 HV auf, oder eine Indentationshärte HIT zwischen 27 GPa und 38 GPa.

Gemäss einer weiteren bevorzugten Ausführungsform der vorliegenden Erfindung weist die Mo-N basierte Hartstoffschicht Eigenspannungen bzw. Druckeigenspannungen auf, welche zwischen -1 Pa und -9 Pa liegen.

Vorzugsweise liegen die Eigenspannungen zwischen -2 Pa und -8 Pa.

Gemäss noch einer weiteren bevorzugten Ausführungsform der vorliegenden Erfindung wird die Oberfläche der Mo-N basierten Hartstoffschicht nachträglich mittels eines Bürstverfahrens nachbehandelt. Vorzugsweise weisst die so nachbehandelte Oberfläche der Mo-N basierten Hartstoffschicht eine Oberflächenrauheit auf, welche durch Rpkx < Rvkx gekennzeichnet ist.

Eine Beschichtung gemäss der vorliegenden Erfindung wird vorzugsweise mit Hilfe von PVD-Techniken hergestellt.

Vorzugsweise wird zumindest die Mo-N basierte Schicht einer Beschichtung gemäss der vorliegenden Erfindung in einer Vakuumbeschichtungskammer mittels Arc-Verdampfen von mindestens einem zumindest grösstenteils Molybdän umfassenden Target in einer zumindest grösstenteils Stickstoffgas-haltigen Atmosphäre auf eine Substratoberfläche abgeschieden, wobei die Beschichtungstemperatur zumindest während des grössten Teils der Abscheidungszeit der Mo-N basierten Hartstoffschicht unter 300 °C gehalten wird.

Die Beschichtungstemperatur bei der Abscheidung der Mo-N basierten Hartstoffschicht ist vorzugsweise ≤ 280 °C, noch bevorzugter ≤ 250 °C, noch besonders bevorzugter ≤ 225 °C.

Im Rahmen der vorliegenden Erfindung sollte man unter dem Begriff Beschichtungstemperatur die Temperatur der zu beschichtenden Substrate während der Abscheidung der Mo-N basierten Hartstoffschicht verstehen.

Vorzugsweise wird zumindest während des grössten Teils der Abscheidungszeit der Mo-N basierten Hartstoffschicht möglichst nur Stickstoffgas in die Beschichtungskammer eingelassen. Minimale Mengen von anderen Gasen (z.B. minimale Mengen von Argon oder Krypton oder Sauerstoff oder Kohlenstoff oder Wasserstoff, etc.) in der Beschichtungsatmosphäre sollten grundsätzlich kein Problem für die Herstellung der erfindungsgemässen Schichten darstellen.

Vorzugsweise wird zumindest während des grössten Teils der Abscheidungszeit der Mo-N basierten Hartstoffschicht eine negative Bias-Spannung am zu beschichtenden Substrat angelegt.

Vorzugsweise werden zur Abscheidung der Mo-N basierten Hartstoffschicht nur Targets verwendet, welche im Wesentlichen aus Molybdän bestehen.

Erstaunlicherweise ist das Prozess-Parameterfenster hinsichtlich der Auswahl von Prozessparametern wie Stickstoffdruck und Bias-Spannung für die Abscheidung der erfindungsgemässen Mo-N basierten Hartstoffschichten beträchtlich gross, wenn man ein Beschichtungsverfahren gemäss der vorliegenden Erfindung verwendet.

Die Erfindung wird anhand der folgenden Abbildungen und Beispiele näher erläutert:
- Die Abbildung 1 zeigt die für die Abscheidung von erfindungsgemässen und nicht erfindungsgemässen Mo-N basierten Schichten verwendeten Beschichtungsparameter, wobei die erfindungsgemässen Schichten mindestens grösstenteils die Delta-Phase des Molybdännitrids umfassen.

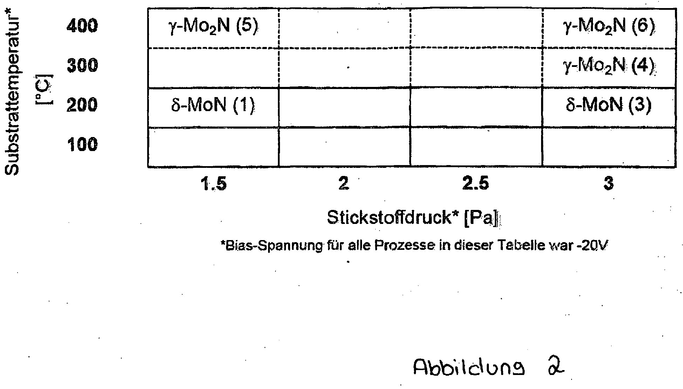

- Die Abbildung 2 zeigt den Einfluss der Beschichtungstemperatur und des Stickstoffdrucks auf die Bildung der hexagonalen Delta- und der kubischen Gamma-Phase des Molybdännitrids bei konstanter Bias-Spannung (im Rahmen der vorliegenden Erfindung, insbesondere in der Abb. 2, ist auch die Zeta-Phase gemeint oder eine Mischung von Gamma- und Zeta-Phase gemeint, wenn über Gamma-Phase gesprochen wird).

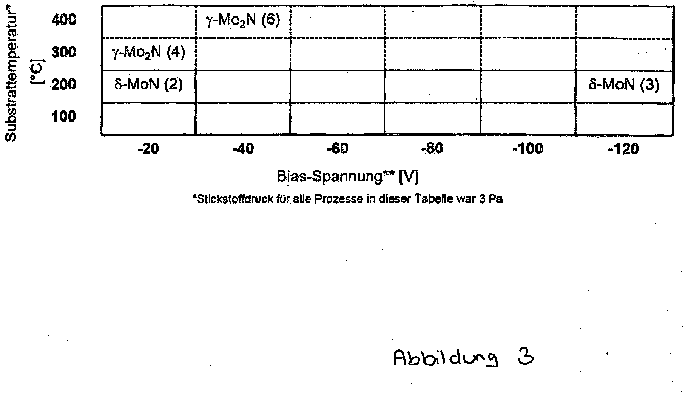

- Die Abbildung 3 zeigt den Einfluss der Beschichtungstemperatur und der Bias-Spannung auf die Bildung der Delta- und Gamma-Phase des Molybdännitrids bei konstantem Stickstoffdruck (im Rahmen der vorliegenden Erfindung, insbesondere in der Abb. 3, ist auch die Zeta-Phase gemeint oder eine Mischung von Gamma-und Zeta-Phase gemeint, wenn über Gamma-Phase gesprochen wird).
- Die Abbildung 4 zeigt die XRD-Diffraktogramme (T2T mit Blende bei 1 mm und GI) der Mo-N Schicht, die gemäss dem erfinderischen Beispiel 1 abgeschieden wurde.
- Die Abbildung 5 zeigt die XRD-Diffraktogramme (T2T mit Blende bei 1 mm und bei 0.2 mm und GI) der Mo-N Schicht, die gemäss dem erfinderischen Beispiel 2 abgeschieden wurde.
- Die Abbildung 6 zeigt die XRD-Diffraktogramme (T2T mit Blende bei 1 mm und GI) der Mo-N Schicht, die gemäss dem erfinderischen Beispiel 3 abgeschieden wurde.
- Die Abbildung 7 zeigt sowohl die XRD-Diffraktogramme (T2T mit Blende bei 1 mm und GI) der gemäss dem erfinderischen Beispiel 1 abgeschieden Mo-N Schicht (unten) als auch die XRD-Diffraktogramme (T2T mit Blende bei 1 mm und GI) der gemäss dem nicht erfinderischen Beispiel 5 abgeschieden Mo-N Schicht (oben).
- Die Abbildung 8 zeigt die Rauigkeitswerte Rz, Rpkx, Rpk und Rvkx von erfindungsgemäss hergestellten Mo-N basierten Hartstoffschichten, deren Oberfläche mit Hilfe eines Bürstverfahrens unterschiedlich nachbehandelt wurde.

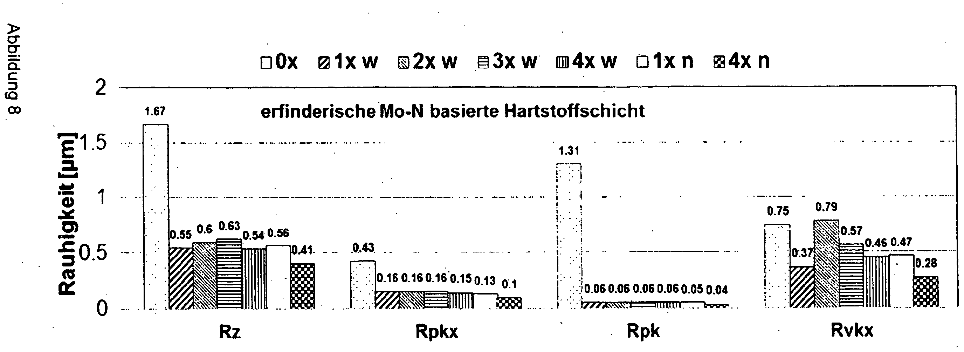

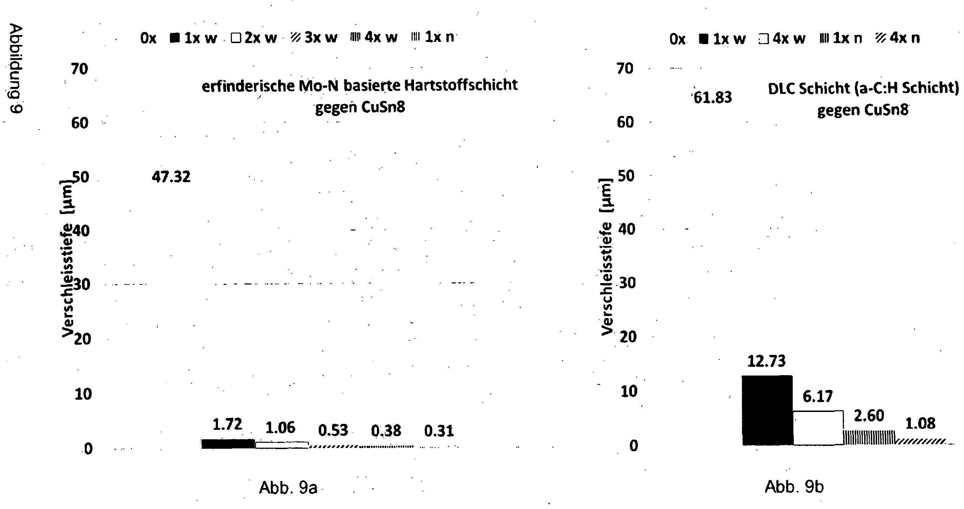

Die Abbildung 9 zeigt den Gegenkörperverschleiss, der bei Tests mit beschichteten Kolbenbolzen gemessen wurde. Die Tests wurden sowohl mit nach der Beschichtung nicht nachbehandelten Kolbenbolzen (0x) als auch mit nach der Beschichtung nachbehandelten Kolbenbolzen durchgeführt. Die Abb. 9a zeigt die Ergebnisse bei Tests, bei denen die Kolbenbolzen mit Mo-N Schichten beschichtet wurden. Die Abb. 9b zeigt die Ergebnisse bei gleichen Tests, aber bei denen die Kolbenbolzen mit DLC-Schichten des Typs a-C:H beschichtet wurden. Sowohl für die in der Abbildung 8 als auch in der Abbildung 9 dargestellten Untersuchungen wurden jeweils die mit Mo-N (Abb. 8 und Abb. 9a) und mit DLC (Abb. 9b) beschichteten Bauteiloberflächen wie folgt nachbehandelt:
∘ 0x: keine Nachbehandlung,
∘ 1x w: 1-mal schwache Bürstenbehandlung,
∘ 2x w: 2-mal schwache Bürstenbehandlung,
∘ 3x w: 3-mal schwache Bürstenbehandlung,
∘ 4x w: 4-mal schwache Bürstenbehandlung,
∘ 1x n: 1 -mal starke Bürstenbehandlung,
∘ 4x n: 4-mal starke Bürstenbehandlung.

Wenn im Rahmen der vorliegenden Erfindung von der Bildung der Gamma Phase des Molybdännitrids (γ-Mo₂N) berichtet wird, soll eher die Bildung einer kubischen Phase des Molybdännitrids verstanden werden, d.h. die Bildung der Gamma- oder der Zeta-Phase oder sogar die Bildung einer Mischung der beiden kubischen Phasen sowohl Gamma als auch Zeta.

Die Zeta-Phase (ζ-MoN) ist auch eine kubische Phase des Molybdännitrids wie die Gamma-Phase, welche aber im Vergleich mit der Gamma-Phase (γ-Mo₂N) mehr Stickstoff aufweist. Der Stickstoffgehalt kann in der Zeta-Phase sogar in den überstöchiometrischen Bereich gehen (mehr N als Mo). In XRD-Diffraktogrammen kann die Gamma- kaum von der Zeta-Phase unterschieden werden, weil diese beiden Phasen, wie bereits oben erwähnt, kubisch sind. Deshalb kann die Bildung einer dieser beiden Phasen erst genauer festgestellt werden, wenn beispielsweise eine detaillierte Analyse der chemischen Zusammensetzung gemacht wird. Jedoch, wenn mehrere Phasen in der Schicht vorhanden sind, ist eine genaue Feststellung der Gamma- oder Zeta-Phase sehr schwierig. Deswegen wurde in der vorliegenden Beschreibung der Erfindung vielfach über γ-Mo₂N berichtet, obwohl es sich genauso gut um die ζ-MoN handeln kann. Da die zurzeit vorhandenen Referenzen aus der Literatur hinsichtlich XRD- Diffraktogramme von kubischen Phasen des Molybdännitrids immer die Bezeichnung γ-Phase verwenden, wird in der vorliegenden Erfindung über die Gamma-Phase und nicht einfach über eine kubische Phase des Molybdännitrids berichtet, obwohl es sich auch um die Zeta-Phase handeln kann.

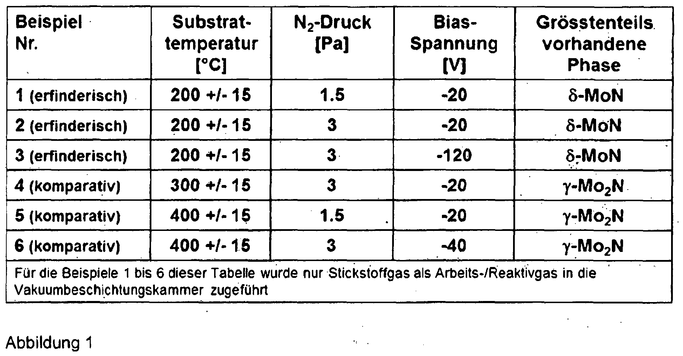

Die Abbildung 1 zeigt eine Tabelle mit einigen ausgewählten Beispielen von Abscheidungsprozessen, wobei in den Beispielen 1 bis 3 erfindungsgemässe und in den Beispielen 4 bis 6 nicht erfindungsgemässe Mo-N Hartstoffschichten abgeschieden wurden.

Für die XRD-Untersuchungen im Rahmen der vorliegenden Erfindung wurden folgende Geräte und Messprogramme verwendet:
XRD-Gerät:
   ∘ Kupferanode,
   ∘ Generatorspannung: 40 kV
   ∘ Generatorstrom: 30 mA
   ∘ 1 oder 0.2 mm Spaltblende (0.2 mm wurde nur im Fall des Beispiels 2 verwendet, weil für die Messung mit einer Spaltblende von 1 mm das Signal in die Sättigung gegangen ist).
Messprogramm Theta 2 Theta (T2T):
   ∘ T2T Bereich: 20-80°
   ∘ Schrittweite: 0.02°
   ∘ Zeit/Schritt: 1 Sekunde
Messprogramm Glancing Incidence (GI):
   ∘ Einstrahlwinkel: 2°
   ∘ T2T Bereich: 20-80°
   ∘ Schrittweite: 0.02°
   ∘ Zeit/Schritt: 1 Sekunde

Für die Beispiele und Untersuchungen wurden Prüfkörper aus Schnellarbeitsstahl 1.2842 90MnCrV8 und Gleitelemente aus verschiedenen Schnellarbeitsstahlsorten sowie handelsübliche Kolbenbolzen (für die Versuche mit beschichteten und nachgebürsteten Kolbenbolzenoberflächen) in einer Arc-Anlage der Firma Oerlikon Balzers Coating AG beschichtet. In allen Beispielen wurden Molybdäntargets mittels Arc-PVD in einer Stickstoffatmosphäre verdampft. Der Prozessdruck bzw. der Stickstoffdruck wurde durch Steuerung des Stickstoffgasflusses in der Beschichtungskammer konstant gehalten. Eine Bias-Spannung wurde an den zu beschichteten Substraten angelegt. Gleiche Arc-Beschichtungsquellen und Arc-Stromwerte wurden für alle Prozesse verwendet. Nur die Beschichtungstemperatur, der Stickstoffdruck und die Bias-Spannung wurden gemäss den Angaben in Abbildung 1 variiert.

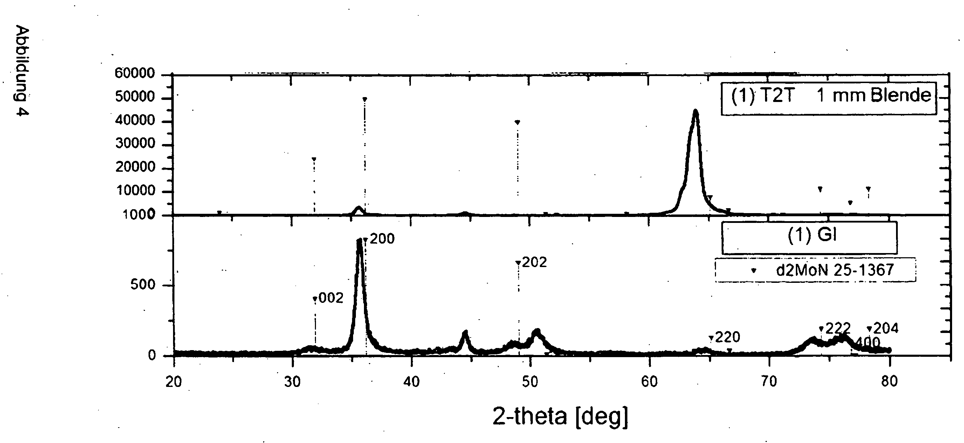

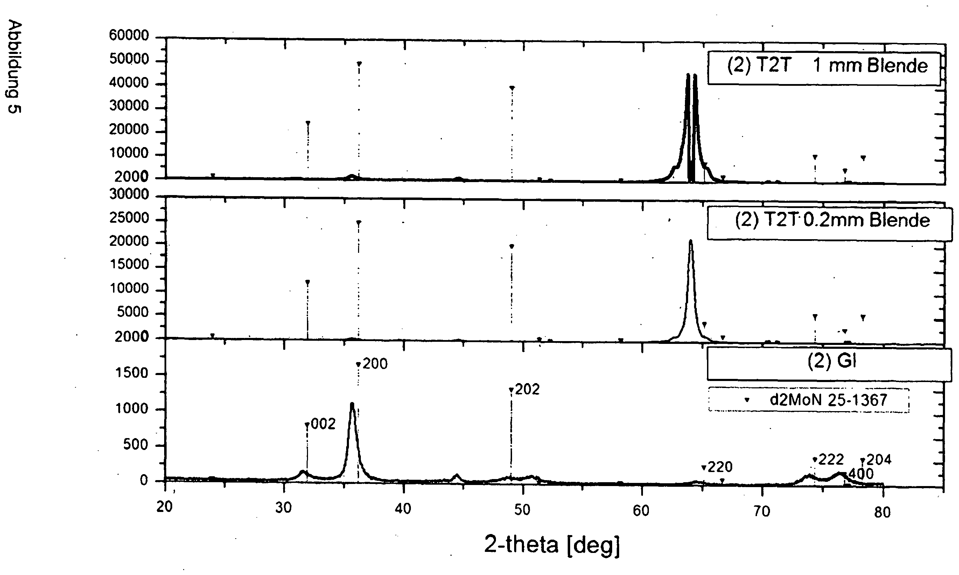

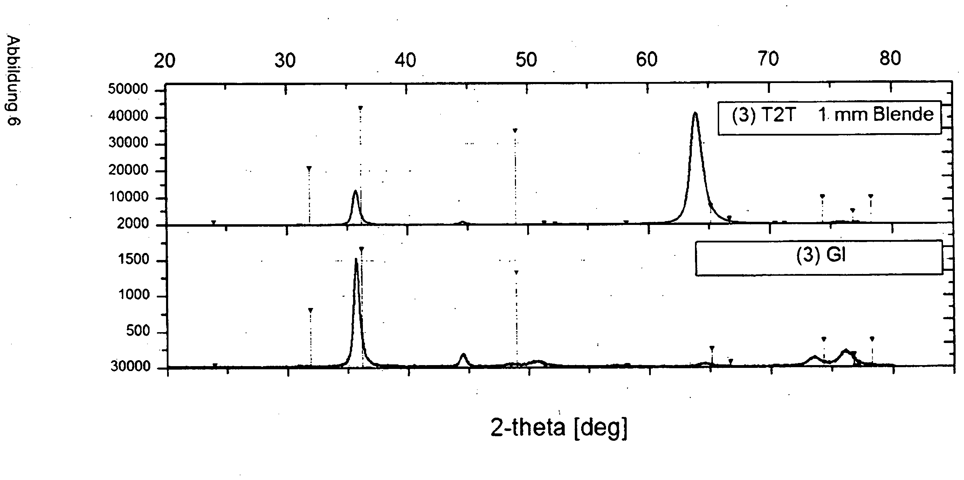

Die in den Beispielen 1, 2 und 3 hergestellten Mo-N basierten Hartstoffschichten, welche erfindungsgemäss unter Verwendung einer Beschichtungstemperatur von 200 °C +/- 15 °C abgeschieden wurden, umfassen mindestens grösstenteils die Delta-Phase des Molybdännitrids. Sogar falls ein niedriger N₂-Druck von 1.5 Pa (wie in Abb. 1 , Beispiel 1 angegeben) oder eine hohe negative Bias-Spannung von - 20 V (wie in Abb. 1, Beispiel 3 angegeben) verwendet wurde, konnte die Bildung der Delta-Phase des Molybdännitrids festgestellt werden, wie es aus den entsprechenden XRD-Diffraktogrammen in den Abbildungen 4, 5 und 6 zu entnehmen ist.

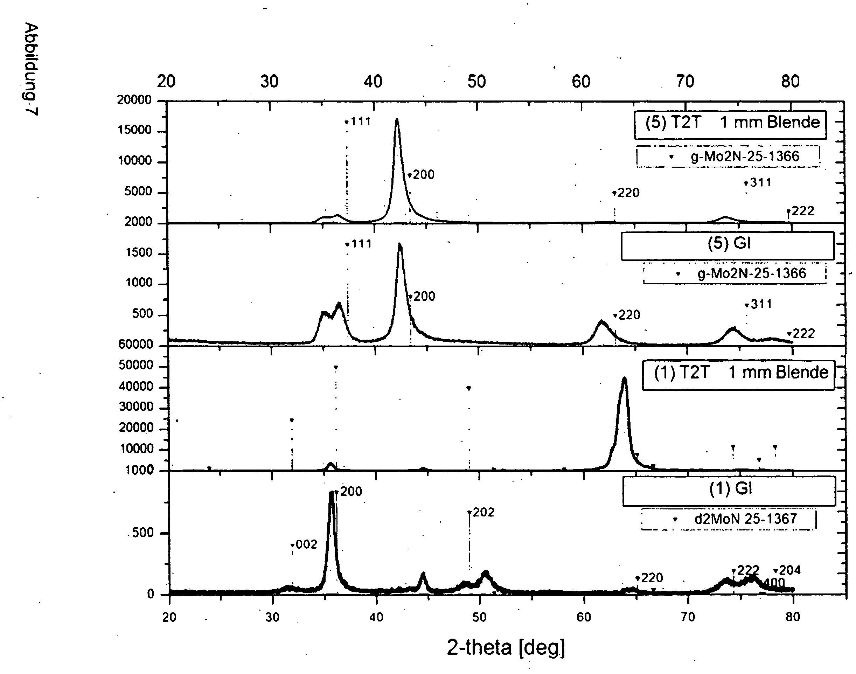

Hingegen zeigen die XRD-Diffraktogramme der gemäss den Beispielen 4, 5 und 6 hergestellten Schichten, bei denen eine Beschichtungstemperatur von 300 °C oder höher verwendet wurde, eine kubische Struktur, welche auf die Bildung der Gamma-und oder Zeta-Phase des Molybdännitrids hinweist (siehe das XRD-Diffraktogramm einer Mo-N basierten Schicht gemäss dem Beispiel 5 (5) in der Abbildung 7).

In der Abbildung 7 sieht man deutlich den Unterschied zwischen den zwei dargestellten XRD-Diffraktogrammen von jeweils einer erfinderischen Mo-N basierten Hartstoffschicht (Beispiel 1 (1)) und einer nicht erfinderischen Mo-N basierten Hartstoffschicht (Beispiel 5 (5)).

Vorzugsweise beträgt die Beschichtungstemperatur für die Abscheidung einer Mo-N basierten Hartstoffschicht gemäss der vorliegenden Erfindung mindestens 50 °C, noch bevorzugter mindestens 100 °C, besonders bevorzugt mindestens 150 °C.

Weiterhin konnten die Erfinder feststellen, dass durch die Verwendung einer Beschichtungstemperatur nicht höher als 200 °C +/- 50 °C sogar erfindungsgemässe Mo-N Schichten hergestellt werden können, wenn ein Stickstoffdruck von weniger als 1.5 Pa oder mehr als 6 Pa und/oder eine negative Bias-Spannung geringer (im Absolut-Wert) als -20 V oder grösser (im Absolut-Wert) als -120 V verwendet wird.

Weitere Details von Ausführungsformen oder bevorzugten Ausführungsformen der vorliegenden Erfindung:
Erfindungsgemäss wird vorzugsweise eine Bias-Spannung von -10 V bis -150 V verwendet.

Erfindungsgemäss wird vorzugsweise ein Stickstoffdruck von 1 Pa bis 6 Pa verwendet.

Wie oben bereits erwähnt, weisen die erfindungsgemäss hergestellten Mo-N Schichten die charakteristische hexagonale Struktur der Delta-Phase des Molybdännitrids auf. Gleichzeitig weisen die erfindungsgemäss hergestellten Schichten eine Vickershärte zwischen 2600 HV und 3700 HV oder eine Indentationshärte HIT zwischen 26-27 GPa und 37-38 GPa auf.

Gemäss einer bevorzugten Ausführungsform einer Beschichtung mit mindestens einer Mo-N Schicht gemäss der vorliegenden Erfindung weisen die erfindungsgemässen Mo-N Schichten ein E-Modul zwischen 300 GPa und 500 GPa auf, vorzugsweise zwischen 330 und 470 GPa, noch bevorzugter zwischen 350 und 450 GPa.

Gemäss noch einer bevorzugten Ausführungsform einer Beschichtung gemäss der vorliegenden Erfindung weisen die erfindungsgemässen Mo-N Schichten Druckeigenspannungen von -1 GPa bis -9 GPa auf, vorzugsweise von -2GPa bis -8 GPa.

Gemäss noch einer bevorzugten Ausführungsform einer Beschichtung gemäss der vorliegenden Erfindung weisen die erfindungsgemässen Mo-N Schichten eine Indentationshärte HIT grösser 28 GPa und kleiner 37 GPa auf.

Bei tribologischen Untersuchungen haben die Erfinder festgestellt, dass erfindungsgemässe Mo-N Schichten mit einer Vickershärte von 3000 HV bis 3600 HV oder einer Indentationshärte HIT zwischen 30 GPa und 36 GPa für gewisse Anwendungen besonders gut geeignet sind.

Besonders hervorragende Gleiteigenschaften wurden zum Beispiel bei erfindungsgemässen Mo-N Schichten festgestellt, welche eine HIT Härte von 34 GPa bis 35 PGa, eine Fliessgrenze von 31 GPa bis 32 GPa und ein E-Modul von 350 GPa bis 450 GPa aufwiesen.

Wie oben bereits erwähnt, werden die Mo-N Schichten vorzugsweise mittels eines Bürstverfahrens nachbehandelt, um eine gut geeignete Oberflächengüte bzw. Oberflächenrauigkeit zu erreichen, welche insbesondere für tribologische Anwendungen, in denen gute Gleiteigenschaften gefordert werden, wichtig ist.

Die Rauigkeitszunahme in/auf Schichten, die mittels kathodischer Funkenverdampfung (Arc- Verdampfung oder Arc-PVD) hergestellt werden, ist durch das Entstehen von Makropartikeln (Droplets oder Spritzer) aus der Kathode (Target) sehr markant. Eine Nachbehandlung beispielsweise durch Polieren oder Bürsten oder Mikrostrahlen zeigt nicht bei allen Schichten, die mit der kathodischen Funkenverdampfung hergestellt werden, eine deutliche Erniedrigung in der Rauigkeit. Das liegt daran, dass der Einbau der Spritzer in die Schicht unterschiedlich stabil erfolgt und dass sich aus diesem Grunde die Schichten mehr oder weniger gut nachbehandeln lassen.

Für den Fall der erfindungsgemässen Mo-N basierten Hartstoffschichten funktioniert das Nachbehandeln durch Bürsten allerdings sehr gut.

Das ist in Abbildung 8 dargestellt, in der die Rauigkeit von etwa gleich dicken erfindungsgemässen Mo-N basierten Hartstoffschichten (auch im Rahmen der vorliegenden Erfindung einfach Mo-N Schichten oder erfindungsgemässe Mo-N Schichten genannt) vor und nach unterschiedlichen Nachbehandlungen durch Bürsten verglichen wird.

In Abb. 9a ist der Gegenkörperverschleiss eines CuSn8-pins dargestellt, wenn er gegen einen erfindungsgemäss beschichteten Kolbenbolzen läuft. Im Vergleich dazu ist die Verschleisskurve für einen DLC-beschichteten Kolbenbolzen in Abb. 9b dargestellt. In beiden Fällen wurden die vorhin beschriebenen verschiedenen Bürstmethoden mit schwach (w) und stark (n), einfach oder mehrfach Bürsten angewendet. Absolut überraschend ist nun, dass bei gleicher Nachbehandlung die erfindungsgemässen Mo-N Schichten weniger Gegenkörperverschleiss zeigen als entsprechend nachbehandelte DLC-Schichten. Das ist auch überraschend, weil die Ausgangsrauigkeit der Mo-N Schichten wegen der Spritzer (Droplets) höher ist als die der DLC-Schichten. Dies zeigt, wie effektiv sich diese Spritzer mit dem hier erfindungsgemäss vorgeschlagenen industriellen Bürstverfahren entfernen lassen.

Die Erfinder haben festgestellt, dass insbesondere für das Erreichen geringer Rpkx Werte beim Mo-N weniger starke Bürsteinstellungen erforderlich sind, was den Nachbehandlungsprozess einfacher und besser reproduzierbar macht. Zusammenfassend kann man sagen, dass die erfindungsgemässen Mo-N Schichten sich problemlos nachbehandeln lassen und es zu einer deutlichen Reduktion der für die Spitzenrauigkeiten charakteristischen Werte Rpk, Rpkx kommt.

Der hohe Rvkx Wert im Vergleich zum Rpkx Wert begünstigt die Ausbildung von Ölschmiertaschen, die insbesondere bei geringen Ölmengen gute Schmierung sicherstellen.

Um geringen Gegenkörperverschleiss zu erreichen, wird ein Rpkx < 0.3 pm angestrebt, vorzugsweise < 0.2 pm, noch bevorzugter < 0.15 pm.

Gemäss einer besonders bevorzugten Ausführungsform der vorliegenden Erfindung weisen die Mo-N Schichten einen Stickstoffgehalt von 45 at% bis 55 at% auf.

Das gemessene Verhältnis in Atom% zwischen Stickstoff- und Molybdän-Gehalt in erfindungsgemässen Schichten, welche beim Betrieb von Molybdän-Targets als Kathoden in einem Arc-PVD-Verfahren, bei dem ein Arc-Strom von 220 A; eine Beschichtungstemperatur (=Substrattemperatur) von 200 °C, eine negative Bias-Spannung von -20 V und ein Stickstoffdruck von 3 Pa verwendet wurden, war nahezu 50:50.

Gemäss einer weiteren Ausführungsform der vorliegenden Erfindung wird eine Haftschicht als Interface zwischen dem zu beschichtenden Substrat und der Molybdännitrid-Schicht abgeschieden. Als Haftschicht in diesem Zusammenhang eignen sich Cr oder/und CrN-Schichten besonders gut, vorzugsweise mit einer Dicke kleiner 60 nm, je nach Anwendung besonders bevorzugt zwischen 10 nm und 50 nm.

Gemäss einer höchst bevorzugten Ausführungsform einer Methode gemäss der vorliegenden Erfindung, wird die erfindungsgemäss hergestellte Mo-N Hartstoffschicht als äusserste Schicht der Beschichtung mittels Arc-Verdampfen von Molybdän-Targets in einer Stickstoffatmosphäre abgeschieden und nachträglich mittels eines Bürstverfahrens nachbehandelt, bis eine Oberflächenrauigkeit mit Rpkx < Rvkx erreicht wird.

## Patentansprüche

1. Beschichtung umfassend zumindest eine Mo-N basierte Hartstoffschicht, welche zumindest grösstenteils die hexagonale Phase des Molybdännitrids δ-MoN umfasst, **dadurch gekennzeichnet, dass** das Intensitätsverhältnis der beiden Peaks (δ-MoN 220)/(δ-MoN 200) in einem XRD-Diffraktogramm ≥ 3 ist.

2. Beschichtung nach Anspruch 1, **dadurch gekennzeichnet, dass** die Mo-N basierte Hartstoffschicht im Wesentlichen aus Molybdännitrid besteht.

3. Beschichtung nach einem der vorangehenden Ansprüche, **dadurch gekennzeichnet, dass** das Intensitätsverhältnis der beiden Peaks (δ-MoN 220)/(δ-MoN 200) ≥ 10 ist.

4. Beschichtung nach Anspruch 3, **dadurch gekennzeichnet, dass** das Intensitätsverhältnis der beiden Peaks (δ-MoN 220)/(δ-MoN 200) ≥ 30 ist.

5. Beschichtung nach einem der vorangehenden Ansprüche, **dadurch gekennzeichnet, dass** die Mo-N basierte Hartstoffschicht eine Vickershärte zwischen 2600 HV und 3700 HV oder eine HIT Härte zwischen 27 und 38 GPa aufweist.

6. Beschichtung nach Anspruch 5, **dadurch gekennzeichnet, dass** die HIT Härte grösser 28 GPa und kleiner 38 GPa oder kleiner 37 GPa ist.

7. Beschichtung nach einem der vorangehenden Ansprüche, **dadurch gekennzeichnet, dass** die Mo-N basierte Hartstoffschicht Druckeigenspannungen aufweist, welche im Bereich zwischen -1 GPa und -9 GPa liegen.

8. Beschichtung nach Anspruch 7, **dadurch gekennzeichnet, dass** die Druckeigenspannungen im Bereich zwischen -2 GPa und -8 GPa liegen.

9. Beschichtung nach einem der vorangehenden Ansprüche, **dadurch gekennzeichnet, dass** die Mo-N basierte Hartstoffschicht ein E-Modul zwischen 300 GPa und 500 GPa, vorzugsweise zwischen 330 GPa und 470 GPa, noch bevorzugter zwischen 350 GPa und 450 GPa aufweist.

10. Substrat, vorzugsweise Werkzeug oder Bauteil, noch bevorzugter Gleitelement, mit einer Beschichtung nach einem der vorangehenden Ansprüche.

11. Beschichtetes Substrat nach Anspruch 10, **dadurch gekennzeichnet, dass** zumindest eine Zwischenschicht zwischen der Substratoberfläche und der Mo-N basierten Hartstoffschicht vorhanden ist, welche vorzugsweise Chromnitrid umfasst oder aus Chromnitrid besteht.

12. Verfahren zur Abscheidung einer Beschichtung nach einem der vorangehenden Ansprüche 1 bis 9, **dadurch gekennzeichnet, dass** zumindest die Mo-N basierte Hartstoffschicht mittels eines Arc-PVD-Verfahrens auf eine zu beschichtende Substratoberfläche abgeschieden wird, wobei mindestens ein zumindest grösstenteils Molybdän umfassendes Target, vorzugsweise ein Target aus Molybdän, in einer mindestens grösstenteils stickstoffhaltigen Atmosphäre Arc-verdampft wird und zumindest während des grössten Teils der Abscheidungszeit der Mo-N basierten Hartstoffschicht, vorzugsweise während der vollen Abscheidungszeit der Molybdännitrid-Schicht, eine Beschichtungstemperatur unter 300 °C verwendet wird, vorzugsweise unter 280 °C, noch bevorzugter unter 200°C +/- 50°C.

13. Verfahren nach Anspruch 12, **dadurch gekennzeichnet, dass** zumindest während des grössten Teils der Abscheidungszeit der Molybdännitrid-Schicht, vorzugsweise während der vollen Abscheidungszeit der Molybdännitrid-Schicht, eine negative Bias-Spannung am zu beschichtenden Substrat angelegt wird.

## Claims

1. A coating comprising at least one Mo-N-based hard material layer, which at least largely comprises the hexagonal phase of molybdenum nitride δ-MoN, **characterized in that** the intensity ratio of the two peaks (δ-MoN 220)/(δ-MoN 200) in an XRD diffraction pattern is ≥ 3.

2. The coating according to claim 1, **characterized in that** the Mo-N-based hard material layer consists essentially of molybdenum nitride.

3. The coating according to one of the preceding claims, **characterized in that** the intensity ratio of the two peaks (δ-MoN 220)/(δ-MoN 200) is ≥ 10.

4. The coating according to claim 3, **characterized in that** the intensity ratio of the two peaks (δ-MoN 220)/(δ-MoN 200) is ≥ 30.

5. The coating according to one of the preceding claims, **characterized in that** the Mo-N-based hard material coating has a Vickers hardness between 2600 HV and 3700 HV or a HIT hardness between 27 and 38 GPa.

6. The coating according to claim 5, **characterized in that** the HIT hardness is greater than 28 GPa and less than 38 GPa or less than 37 GPa.

7. The coating according to one of the preceding claims, **characterized in that** the Mo-N-based hard material layer has residual compressive stresses that lie in the range between -1 GPa and -9 GPa.

8. The coating according to claim 7, **characterized in that** the residual compressive stresses lie in the range between -2 GPa and -8 GPa.

9. The coating according to one of the preceding claims, **characterized in that** the Mo-N-based hard material layer has an e-modulus between 300 GPa and 500 GPa, preferably between 330 GPa and 470 GPa, and even more preferably between 350 GPa and 450 GPa.

10. A substrate, preferably a tool or component, even more preferably a sliding element, having a coating according to one of the preceding claims.

11. The coated substrate according to claim 10, **characterized in that** there is at least one intermediate layer between the substrate surface and the Mo-N-based hard material layer that preferably comprises chromium nitride or consists of chromium nitride.

12. A method for depositing a coating according to one of the preceding claims 1 through 9, **characterized in that** at least the Mo-N-based hard material coating is deposited by means of an arc PVD process onto a substrate surface to be coated, wherein at least one target comprising at least largely molybdenum, preferably a target composed of molybdenum, is arc evaporated in an atmosphere containing at least largely nitrogen, and during at least most of the deposition time of the Mo-N-based hard material layer, preferably during the entire deposition time of the Mo-N-based hard material layer, a coating temperature below 300°C is used, preferably below 280°C, and even more preferably below 200°C +/- 50°C.

13. The method according to claim 12, **characterized in that** at least during most of the deposition time of the molybdenum nitride layer, preferably during the entire deposition time of the molybdenum nitride layer, a negative bias voltage is applied onto the substrate to be coated.

## Revendications

1. Revêtement incluant au moins une couche de matière dure à base de MoN, qui inclut au moins en majeure partie la phase hexagonale du nitrure de molybdène δ-MoN,
**caractérisé en ce que** le rapport d'intensité des deux pics (δ-MoN 220)/(δ-MoN 200) dans un diffractogramme XRD est ≥ 3.

2. Revêtement selon la revendication 1, **caractérisé en ce que** la couche de matière dure à base de Mo-N est essentiellement constituée de nitrure de molybdène.

3. Revêtement selon l'une des revendications précédentes, **caractérisé en ce que** le rapport d'intensité des deux pics (δ-MoN 220)/(δ-MoN 200) est ≥ 10.

4. Revêtement selon la revendication 3, **caractérisé en ce que** le rapport d'intensité des deux pics (δ-MoN 220)/(δ-MoN 200) est ≥ 30.

5. Revêtement selon l'une des revendications précédentes, **caractérisé en ce que** la couche de matière dure à base de Mo-N présente une dureté Vickers entre 2600 HV et 3700 HV, ou une dureté HIT entre 27 et 38 GPa.

6. Revêtement selon la revendication 5, **caractérisé en ce que** la dureté HIT est supérieure à 28 GPa est inférieure à 38 GPa ou inférieure à 37 GPa.

7. Revêtement selon l'une des revendications précédentes, **caractérisé en ce que** la couche de matière dure à base de Mo-N présente des tensions propres sous pression, qui sont situées dans la plage entre -1 GPa et -9 GPa.

8. Revêtement selon la revendication 7, **caractérisé en ce que** les tensions propres sous pression sont situées dans la plage entre - 2 GPa et - 8 GPa.

9. Revêtement selon l'une des revendications précédentes, **caractérisé en ce que** la couche de matière dure à base de Mo-N présente un module E entre 300 GPa et 500 GPa, de préférence entre 330 GPa et 470 GPa, et de manière encore plus préférée entre 350 GPa et 450 GPa.

10. Substrat, de préférence outil ou composant, et de manière encore plus préférée élément coulissant, avec un revêtement selon l'une des revendications précédentes.

11. Substrat revêtu selon la revendication 10, **caractérisé en ce qu'**il existe au moins une couche intermédiaire entre la surface du substrat et la couche de matière dure à base de Mo-N, qui inclut de préférence du nitrure de chrome ou qui est constituée par du nitrure de chrome.

12. Procédé pour la déposition d'un revêtement selon l'une des revendications précédentes 1 à 9, **caractérisé en ce que** au moins la couche de matière dure à base de Mo-N est déposée au moyen d'une procédure de déposition physique en phase vapeur au moyen d'un arc sur une surface d'un substrat à revêtir, et au moins une cible qui inclut au moins en majeure partie du molybdène, de préférence une cible en molybdène, et amenée à vaporiser au moyen d'un arc dans une atmosphère contenant au moins en majeure partie de l'azote et, au moins pendant la majeure partie du temps de déposition de la couche de matière dure à base de Mo-N, et de préférence pendant la totalité du temps de déposition de la couche de nitrure de molybdène, on utilise une température de revêtement au-dessous de 300° C, de préférence au-dessous de 280° C, et de manière encore préférée au-dessous de 200° C ± 50° C.

13. Procédé selon la revendication 12, **caractérisé en ce que** au moins pendant la majeure partie du temps de déposition de la couche de nitrure de molybdène, et de préférence pendant la totalité du temps de déposition de la couche de nitrure de molybdène, on applique une tension de polarisation négative au substrat à revêtir.
